Europäisches Patentamt

(19) European Patent Office (11) Numéro de publication: **0 044 774**
**B1**
Office européen des brevets

(12) **FASCICULE DE BREVET EUROPEEN**

(45) Date de publication du fascicule du brevet: (51) Int. Cl.³: **H 03 D 9/06**
07.03.84

(21) Numéro de dépôt: **81401125.0**

(22) Date de dépôt: **10.07.81**

(54) **Mélangeur hybride à élévation de fréquence.**

(30) Priorité: **18.07.80 FR 8015906** (73) Titulaire: **LMT RADIO PROFESSIONNELLE, 46-47, Quai Alphonse Le Gallo, F-92103 Boulogne-Billancourt (FR)**

(43) Date de publication de la demande: **27.01.82 Bulletin 82/4** (72) Inventeur: **Marchand, Maurice, THOMSON-CSF SCPI 173, Bld. Haussmann, F-75360 Paris Cedex 08 (FR)** Inventeur: **Petijean Christian, THOMSON-CSF SCPI 173, Bld. Haussmann, F-75360 Paris Cedex 08 (FR)**

(45) Mention de la délivrance du brevet: **07.03.84 Bulletin 84/10**

(74) Mandataire: **Desperrier, Jean-Louis et al, THOMSON-CSF SCPI 173, Bld Haussmann, F-75379 Paris Cedex 08 (FR)**

(84) Etats contractants désignés: **BE CH DE GB IT LI NL SE**

(56) Documents cités:
**DE - A - 1 197 134**
**FR - A - 2 241 918**
**GB - A - 1 121 790**
**GB - A - 1 345 577**
**US - A - 2 789 210**
**US - A - 4 031 472**

Mélangeur hybride a élévation de fréquence

La présente invention se rapporte aux mélangeurs hybrides à élévation fréquence, qui permettent à partir de deux signaux radioélectriques d'obtenir un troisième signal radioélectrique dont la fréquence est supérieure à celle des deux premiers signaux. De tels mélangeurs sont particulièrement utiles pour les radars Doppler cohérents dans lesquels tous les signaux sont obtenus à partir d'un oscillateur local à quartz dont la fréquence et la phase sont très stables.

Dans une réalisation particulière d'un tel radar, on utilise comme oscillateur local un quartz dont la fréquence est de 60 MHz. Cette fréquence est relativement basse, mais il est difficile de faire osciller un quartz à une fréquence plus haute, surtout en gardant ses caractéristiques de précision et de stabilité. Pour obtenir le signal d'émission il faut donc procéder à une multiplication de fréquence à partir du signal fourni par le quartz. Cette multiplication se fait à l'aide de toute une chaîne de conversion. Dans cette chaîne on trouve notamment un mélangeur dans lequel on additionne un signal d'une fréquence de 60 MHz à un signal d'une fréquence de 1800 MHz. Le signal en sortie de ce mélanger a donc une fréquence de 1860 MHz. Cette fréquence est supérieure à celle des signaux d'entrée, ce qui est une caractéristique un peu inhabituelle, et c'est la raison pour laquelle on qualifie ce mélangeur de mélangeur à élévation de fréquence. Ce terme correspond au terme anglo-saxon généralement utilisé de «up converter».

Les mélangeurs disponibles dans le commerce peuvent fonctionner en élévation de fréquence. On constate toutefois que leur rendement est alors nettement moins bon et se caractérise par exemple par une chute du niveau de sortie supérieure à quatre décibels entre les deux modes de fonctionnement. De plus ce résultat relativement acceptable n'est obtenu que si les fréquences des signaux à mélanger ne sont pas trop éloignés l'une de l'autre. Ce n'est clairement pas le cas dans le mélangeur du radar décrit ci-dessus.

Il est usuel pour les mélangeurs pouvant fonctionner jusqu'à des fréquences de l'ordre de 1500 MHz, de les réaliser en bobinant des transformateurs équilibrés sur des noyaux magnétiques tels que des tores ou des pots en ferrite.

Au delà de cette fréquence de 1500 MHz, on utilise le plus souvent, comme dans les demandes de brevets allemand DE-1 197 134 et français FR-2 241 918, une technologie hybride comportant des coupleurs ou des anneaux.

Dans le cas de ce radar, la fréquence la plus basse est justifiable de la technologie bobinée, et la fréquence la plus haute de la technologie hybride. Ces deux technologies sont également appelées technologie à constantes localisées et technologie à constantes réparties. Si on réalise un mélangeur avec l'une ou l'autre de ces technologies dans ce cas, les pertes seront trop grandes dans les bobinages sur ferrite pour le signal à 1800 MHz, et les dimensions des coupleurs hybrides seront prohibitives pour le signal à 60 MHz.

Pour pallier ces difficultés, l'invention propose un mélangeur hybride à élévation de fréquence, du type comportant un pont de diodes mélangeuses muni de quatre entrées, des premiers moyens pour alimenter deux de ces entrées par une première onde ayant une première fréquence déterminée, dex deuxièmes moyens pour alimenter les deux autres entrées par une deuxième onde ayant une deuxième fréquence déterminée, et des troisièmes moyens pour extraire une troisième onde dont la fréquence est la somme des première et deuxième fréquences, principalement caractérisé en ce que les première moyens sont réalisés en technologie à constantes localisée, et les deuxièmes moyens en technologie à constantes réparties.

D'autres particularités et avantages de l'invention apparaîtront clairement dans la description suivante présentée à titre d'exemple non limitatif en regard des figures annexées suivantes:

— la figure 1, qui représente le schéma de principe d'un tel mélangeur;

— la figure 2, qui représente une vue de dessus de l'implantation de ce mélangeur sur un circuit hybride.

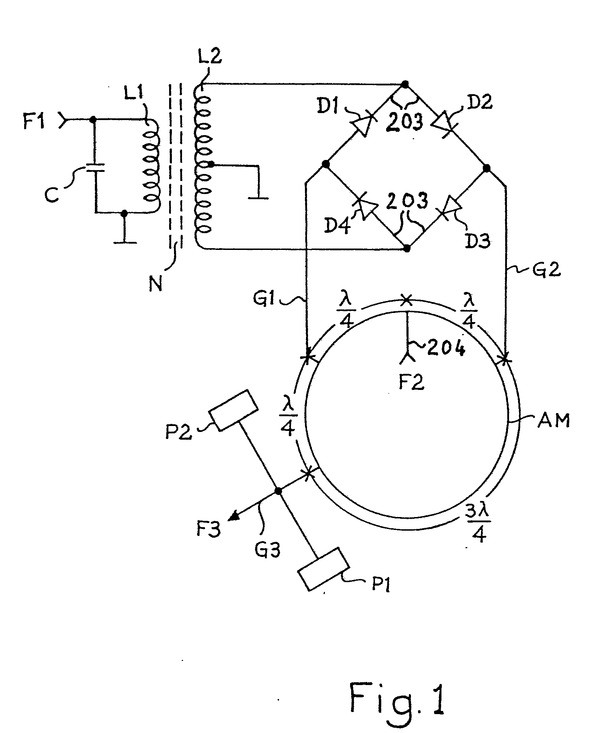

Le mélangeur double équilibré selon l'invention dont le schéma de principe est représenté sur la figure 1, utilise comme élément non linéaire permettant le mélange des fréquences un pont de quatre diodes D1 à D4. La première onde à mélanger F1, est à une Çéquence relativement basse, 60 MHz dans l'exemple décrit. Elle est appliquée à l'une des extrémités d'un primaire L1 bobiné sur un noyau de ferrite N. L'autre extrémité de ce primaire est reliée à la masse. Un condensateur C permet d'accorder ce primaire sur la fréquence de l'onde qui lui est appliquée.

Un secondaire L2 est bobiné sur le même noyau que L1. Il est muni d'un point milieu relié à la masse. L'onde F1 apparaît donc aux extrémités de ce secondaire avec la même amplitude mais avec des phases décalées de 180°.

L'une des extrémités de L2 est reliée à la cathode de D1 et à l'anode de D2. L'autre extrémité est reliée à la cathode de D3 et l'anode de D4.

Cette partie du mélangeur est donc semblable à celle d'un mélangeur radiofréquence réalisé avec des composants discrets.

La deuxième onde F2 à mélanger à F1 est à une fréquence beaucoup plus élevée, 1800 MHz dans l'exemple décrit. Elle est appliquée à une première entrée d'un anneau hybride AM dont la circonférence mesure trois fois la demi-longueur d'onde, dans le milieu où il est réalisé, de l'onde F2, c'est-à-dire $\frac{3\lambda}{2}$.

Selon une propriété bien connue d'un tel anneau, l'onde F2 apparaît à une distance égale à un quart de longueur d'onde, soit $\frac{\lambda}{4}$, de part et d'autre du point d'injection avec la même amplitude et un déphasage total entre ces deux points de 180°.

Elle sort alors en ces deux points de l'anneau AM par deux guides hybrides G1 et G2 qui sont symétriques par rapport à un diamètre passant par le point d'injection de F2. G1 est raccordé à l'anode de D1 et à la cathode de D4, et G2 est raccordé à la cathode de D2 et à l'anode de D3. La longeur de ces guides est la même pour que l'opposition de phase au point d'extraction de l'anneau se garde jusqu'au raccordement avec le pont de diode.

Le mélange de F1 et de F2 dans le pont de diodes provoque l'apparition d'une troisième onde F3 dont la fréquence est la somme des fréquences des ondes incidentes, soit dans l'exemple décrit 1860 MHz.

Cette onde revient dans l'anneau AM qui présente vis-à-vis d'elle, en raison du faible écart de fréquence par rapport à F2, les mêmes caractéristiques de déphasage que pour cette deuxième onde. On peut alors l'extraire de cet anneau, selon une caractéristique elle aussi connue, en un point situé à un quart de longueur d'onde, soit $\frac{\lambda}{4}$, du branchement du guide G1, et à trois quarts de longueur d'onde, soit $\frac{3\lambda}{4}$, du branchement de G2. Un guide G3 connecté en ce point de l'anneau permet d'extraire l'onde F3 pour l'appliquer au dispositif destiné à la recevoir dans le radar. Pour éviter toute interférence avec les résidus de l'onde F2 susceptibles de sortir par G3, deux pièges P1 et P2 accordés sur la fréquence de F2 sont placés de part et d'autre de G3 à une faible distance du point d'extraction. Ils permettent d'atténuer considérablement l'amplitude des résidus de F2 présents sur G3.

Cette deuxième partie du mélangeur est donc très semblable à un mélangeur hyperfréquence réalisé selon la technologie hybride.

Dans une réalisation particulière, correspondant aux fréquences données ci-dessus, on a réalisé le mélangeur en utilisant la technologie connue sous le nom anglo-saxon de «microstrip». Cette technologie consiste à utiliser un sandwich formé d'une couche diélectrique intermédiaire comprise entre deux couches métalliques conductrices. L'une de ces couches sert de plan de masse, et l'autre est gravée selon un procédé quelconque, chimique par exemple, pour obtenir un circuit électrique désiré. Les connexions de ce circuit ont une largeur bien déterminée et forment, compte tenu de la présence du plan de masse et de la couche diélectrique dont la permittivité peut être importante, des lignes (ou des guides) microondes à constantes réparties ayant une impédance caractéristique bien définie et fonction de la largeur de la ligne et de la permittivité du diélectrique.

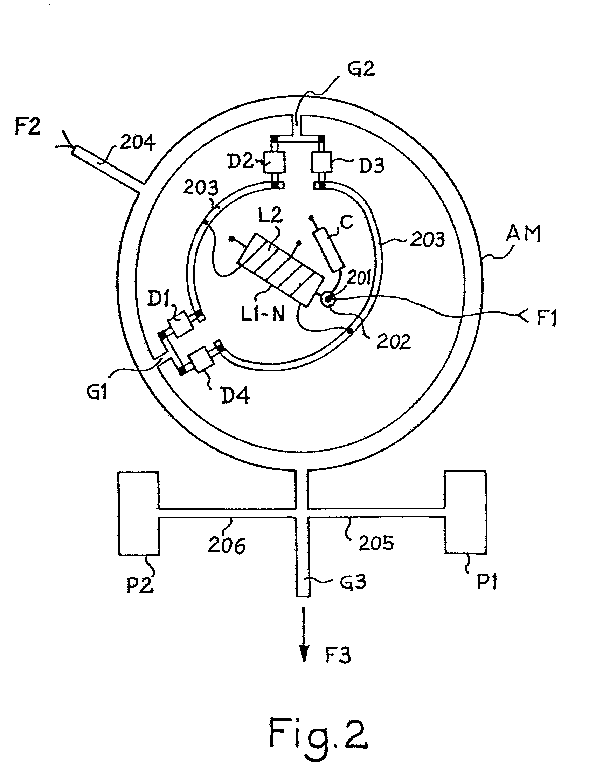

Dans cette réalisation on est parti d'une impédance caractéristique que l'on s'est fixé à 50 ohms, ce qui est une norme très courante. Compte tenu des fréquences utilisées et vues plus haut, et pour obtenir un dispositif dont les dimensions ne soient pas trop importantes, pour des raisons d'encombrement, ni trop petites, pour des raisons de facilité de fabrication, on a utilisé une couche diélectrique formée d'un mélange d'alumine et de téflon dont la permittivité relative est de 10. Cette réalisation est représentée sur la figure 2 à une échelle sensiblement égale à trois et vue du côté de la couche portant les circuits gravés.

Le primaire L1 et le noyau N sont réalisés en prenant une inductance du commerce du type moulé, dont la valeur est choisie pour que lorsqu'elle est accordée avec le condensateur C, son impédance caractéristique soit de 50 ohms. L'une des extrémités de cette inductance traverse la couche diélectrique pour être soudée sur le plan de masse. L'autre extrémité est soudée à une borne (201) elle-même soudée sur une couronne (202) découpée dans la feuille métallique supérieure. Ceci permet de raccorder à cette borne un fil de connexion permettant d'amener la première onde F1.

Sur le corps de l'inductance on a bobiné le secondaire dont un point milieu est relié à travers la couche diélectrique au plan de masse. Les deux extrémités de ce secondaire sont soudées à deux conducteurs de connexion 203 et 204 gravés dans la feuille métallique supérieure.

Tous les éléments sont situés à l'intérieur de l'anneau AM qui présente la forme d'une couronne gravés dans la feuille métallique déposée à la surface de la couche diélectrique et dont la largeur est celle qui donne dans les conditions de réalisation l'impédance voulue de 50 ohms. La circonférence de cette couronne est égale à trois fois la demi-longueur d'onde dans le circuit hybride à la fréquence de 1800 MHz.

L'onde F2 est appliquée par une portion de guide 204 en un point commun de cet anneau AM.

Les guides G1 et G2 sont branchés sur le pourtour interne de l'anneau AM de part et d'autre du point de connexion du guide 204 vers l'intérieur de l'anneau et à une distance égale à un quart de longueur d'onde, soit $\frac{\lambda}{4}$. Ces guides sont très courts et ils se terminent par une petite portion perpendiculaire à la branche connectée à l'anneau et qui leur donne la forme d'un T.

Quatre diodes microondes D1 à D4, présentées sous la forme d'un microboîtier carré courant en technique hyperfréquence, sont connectées respectivement aux extrémités des bras transversaux des guides G1 et G2.

Les autres connexions de ces diodes sont reliées respectivement aux extrémités des connexions 203 elles-mêmes reliées au secondaire L2. On obtient ainsi le pont de quatre diodes dont le schéma est représenté sur la figure 1.

Un guide G3 est connecté à l'anneau AM vers l'extérieur de celui-ci et en un point situé à un quart de longueur d'onde, soit $\frac{\lambda}{4}$, du point de connexion de G1 et du côté opposé au point de connexion du guide 204. Ce guide G3 se trouve donc à une distance sur l'anneau égale à trois quarts de longueur d'onde, soit $\frac{3\lambda}{4}$, du point de connexion du guide G2 sur ce même anneau.

Sur ce guide, et de part et d'autre, sont connectés, à une distance non critique mais suffisamment faible pour ne pas augmenter les dimensions du dispositif et suffisamment grande pour dégager les éléments de l'anneau, deux pièges P1 et P2 ayant la forme de deux rectangles et reliés à G3 par deux fragments de guide 205 et 206. Les dimensions de ces rectangles sont déterminées pour former un piège accordée sur la fréquence de l'onde incidente F2, et la longueur des fragments de guide 205 et 206 est donc sensiblement égale à un quart de longueur d'onde, en relation avec les dimensions des rectangles d'une manière connue.

Dans cette réalisation tous les éléments du mélangeur sont adaptés et accordés aux fréquences des différentes ondes qui les traversent. Ceci permet de minimiser les pertes dans ces éléments et augmenter le découplage des ondes entre elles.

Les mesures effectuées sur un tel circuit, aux fréquences citées dans cet exemple de réalisation, ont montré que la perte de conversion du mélangeur était de sept décibels. Par rapport au résultat des mélangeurs faisant partie de l'état de la technique antérieure, le gain ainsi obtenu est d'au moins trois décibels.

## Revendications

1. Mélangeur hybride à élévation de fréquence, du type comportant un pont de diodes mélangeuses (D1–D4) muni de quatre entrées, des premiers moyens (L1, L2) pour alimenter deux de ces entrées par une première onde ayant une première fréquence déterminée, des deuxièmes moyens (AM, 204, G1, G2) pour alimenter les deux autres entrées par une deuxième onde ayant une deuxième fréquence déterminée, et des troisièmes moyens (G3, P1, P2) pour extraire une troisième onde dont la fréquence est la somme des premières et deuxièmes fréquences, caractérisé en ce que les premiers moyens comprennent un transformateur bobiné sur un noyau de ferrite (N) et comportant un primaire (L1) accordé par un condensateur (C) sur la première fréquence, et un secondaire (L2) à point milieu pour délivrer sur ses deux extrémités la première onde avec la même amplitude et des phases opposées, et que les deuxième et troisième moyens comprennent une première couche métallique formant plan de masse, une deuxième couche métallique sur laquelle sont gravés des conducteurs formant guides d'ondes, et une couche diélectrique placée entre la première et la deuxième couche métallique; les deuxièmes moyens comportant gravés sur la deuxième couche métallique, un anneau (AM) dont la circonférence mesure trois demi-longueurs d'onde à la deuxième fréquence dans cette couche, un premier guide d'onde (204) connecté en un premier point sur l'extérieur de cet anneau pour lui amener la deuxième onde, et un deuxième et un troisième guides d'onde (G1, G2) connectés respectivement d'une part sur l'intérieur de cet anneau de part et d'autre du premier point à un quart de longueur d'onde, et d'autre part aux deux autres entrées du pont de diodes (D1–D4) les bornes des diodes relatives aux premières entrées dudit pont étant respectivement reliées deux à deux, par l'intermédiaire de deux connections (203) gravées sur la deuxième couche métallique, aux éxtrémités du secondaire (L2); et les troisièmes moyens comportant gravés sur la deuxième couche métallique, un quatrième guide d'onde (G3) connecté sur l'extérieur de l'anneau (AM) à un quart de longueur d'onde du deuxième guide d'onde (G1) et à trois quarts de longueur d'onde du troisième guide d'onde (G2), au moins un piège (P1, P2) connecté sur ce quatrième guide d'onde et accordé sur la deuxième fréquence pour ne laisser sortir sur ce quatrième guide d'onde que la troisième onde.

2. Mélangeur selon la revendication 1, caractérisé en ce que le primaire du transformateur est formé d'une inductance moulée (L1, N), et que le secondaire est bobiné sur le corps de cette inductance.

3. Mélangeur selon l'une quelconque des revendications 1 et 2, caractérisé en ce que le transformateur, le condensateur, et les diodes, sont fixés à l'intérieur de l'anneau sur la couche diélectrique du côté de la deuxième couche métallique.

4. Mélangeur selon l'une quelconque des revendications 1 à 3, caractérisé en ce que la première fréquence appartient à la gamme radioélectrique, que les deuxième et troisième fréquences appartiennent à la gamme hyperfréquence.

5. Mélangeur selon la revendication 4, caractérisé en ce que la première fréquence est de sensiblement 60 MHz, la deuxième fréquence de sensiblement 1800 MHz, et la troisième fréquence de sensiblement 1860 MHz.

## Patentansprüche

1. Frequenzerhöhungs-Hybridmischer vom Typ mit einer Mischdiodenbrücke (D1–D4), die mit vier Eingängen versehen ist, mit ersten Mitteln (L1, L2) zur Speisung von zwei dieser Eingänge mit einer ersten Schwingung einer ersten bestimmten Frequenz, zweiten Mitteln (AM, G1, G2) zur Speisung der beiden anderen Eingänge mit einer zweiten Schwingung einer zweiten bestimmten Frequenz und mit dritten Mitteln (G3, P1, P2) zur Entnahme einer dritten Schwingung, deren Frequenz die Summe der ersten und der zweiten Frequenz ist, dadurch gekennzeichnet, dass die ersten Mittel einen Transformator umfassen, welcher auf einen Ferritkern (N) aufgewickelt ist und eine durch einen Kondensator (C) auf die erste Frequenz abgestimmte Primärseite (L1) und eine Sekundärseite (L2) mit einem Mittelpunkt umfasst, um an ihren beiden Enden die erste Schwingung mit derselben Amplitude und entgegengesetzten Phasen abzugeben, und dass die zweiten und die dritten Mittel eine erste Metallschicht, welche die Masseebene bildet, eine zweite Metallschicht, auf der Leiter graviert sind, welche Wellenleiter bilden und eine dielektrische Schicht umfassen, die zwischen der ersten und der zweiten Metallschicht angeordnet ist; wobei die zweiten Mittel auf der zweiten Metallschicht graviert einen Ring (AM), dessen Umfang drei halbe Wellenlängen bei der zweiten Frequenz in dieser Schicht beträgt, einen ersten Wellenleiter (204), der an einem ersten Punkt auf der Aussenseite dieses Ringes angeschlossen ist, um ihm die zweite Schwingung zuzuführen, und einen zweiten sowie einen dritten Wellenleiter (G1, G2) umfassen, die jeweils einerseits mit der Innenseite dieses Ringes auf der einen bzw. anderen Seite des ersten Punktes im Abstand von einer viertel Wellenlänge und andererseits jeweils mit einem der beiden anderen Eingänge der Diodenbrücke (D1–D4) verbunden sind, während die ersten Eingänge der Diodenbrücke über zwei Verbindungen (203), die auf der zweiten Metallschicht graviert sind, mit den Enden der Sekundärseite (L2) verbunden sind; wobei die dritten Mittel auf der zweiten Metallschicht graviert einen vierten Wellenleiter (G3), der an die Aussenseite des Ringes (AM) in einem Abstand von einer viertel Wellenlänge von dem zweiten Wellenleiter (G1) und dreiviertel Wellenlängen von dem dritten Wellenleiter (G2) angeschlossen ist, und wenigstens eine Wellenfalle (P1, P2) umfassen, welche an diesen vierten Wellenleiter angeschlossen und auf die zweite Frequenz abgestimmt ist, um an diesem vierten Wellenleiter nur die dritte Welle durchzulassen.

2. Mischer nach Anspruch 1, dadurch gekennzeichnet, dass die Primärseite des Transformators durch eine vergossene Induktivität (L1, N) gebildet ist und die Sekundärseite auf den Körper dieser Induktivität aufgewickelt ist.

3. Mischer nach einem der Ansprüche 1 und 2, dadurch gekennzeichnet, dass der Transformator, der Kondensator und die Dioden auf der Innenseite des Ringes auf der dielektrischen Schicht auf der Seite der zweiten Metallschicht befestigt sind.

4. Mischer nach einem der Ansprüche 1 bis 3, dadurch gekennzeichnet, dass die erste Frequenz dem radioelektrischen Bereich angehört und die zweite und die dritte Frequenz dem Mikrowellenbereich angehören.

5. Mischer nach Anspruch 4, dadurch gekennzeichnet, dass die erste Frequenz etwa 60 MHz beträgt, die zweite Frequenz etwa 1800 MHz und die dritte Frequenz etwa 1860 MHz beträgt.

**Claims**

1. Frequency elevating hybrid mixer of the type comprising a mixing diode bridge (D1–D4) having four inputs, first means (L1, L2) for feeding two of these inputs with a first wave having a first determined frequency, second means (AM, G1, G2) for feeding the two other inputs with a second wave having a second determined frequency, and third means (G3, P1, P2) for extracting a third wave the frequency of which is the sum of the first and second frequencies, characterized in that the first means comprise a transformer wound onto a ferrite core (N) and comprising a primary (L1) tuned by a capacitor (C) onto the first frequency, a secondary (L2) having a center tap for supplying the first wave with the same amplitude and opposed phases on its two ends, and that the second and third means comprise a first metallic layer forming a ground plane, a second metallic layer on which conductors forming waveguides are engraved, a dielectric layer placed between the first and second metallic layers; the second means comprising, engraved on the second metallic layer, a ring (AM) the periphery of which measures three halfwavelengths at the second frequency within this layer, a first waveguide (204) connected to a first point on the outside of this ring for feeding the second wave thereto, and second and third waveguides (G1, G2) respectively connected, on the one hand, to the inside of this ring on both sides of the first point at a quarter wavelength therefrom and, on the other hand, to the two other inputs of the diode bridge (D1–D4), the first input of the diode bridge being connected to the ends of the secondary (L2) through two connections (203) engraved on the second metallic layer; and the third means comprising, engraved on the second metallic layer, a fourth waveguide (G3) connected to the outside of the ring (AM) at a quarter wavelength from the second waveguide (D1) and at three quarter wavelengths from the third waveguide (G2), and at least one trap (P1, P2) connected to the fourth waveguide and tuned to the second frequency for passing through this fourth waveguide only the third wave.

2. Mixer according to claim 1, characterized in that the primary of the transformer is formed of a molded inductance (L1, N) and that the secondary is wound onto the body of this inductance.

3. Mixer according to any of claims 1 and 2, characterized in that the transformer, the capacitor and the diodes are secured inside the ring onto the dielectric layer on the side of the second metallic layer.

4. Mixer according to any of claims 1 to 3, characterized in that the first frequency belongs to the radioelectric range and the second and third frequencies belong to the hyperfrequency range.

5. Mixer according to claim 4, characterized in that the first frequency is substantially 60 MHz, the second frequency substantially 1800 MHz and the third frequency substantially 1860 MHz.

1/2

Fig.1

2 / 2

Fig.2